# EUROPÄISCHE PATENTSCHRIFT

(11) **EP 2 850 703 B1**
(45) Veröffentlichungstag und Bekanntmachung des Hinweises auf die Patenterteilung: **18.12.2019**
(21) Anmeldenummer: 13718337.2
(22) Anmeldetag: 25.04.2013
(51) Int. Cl.: H01R 13/66, H01R 31/06

(54) **KLEMMENBLOCK, DAMIT GEBILDETE ANSCHLUSSVORRICHTUNG SOWIE FELDGERÄT MIT EINER SOLCHEN ANSCHLUSSVORRICHTUNG**
TERMINAL BLOCK, CONNECTION APPARATUS WHICH IS FORMED WITH SAID TERMINAL BLOCK, AND FIELD DEVICE HAVING A CONNECTION APPARATUS OF THIS KIND
BLOC DE JONCTION, DISPOSITIF DE CONNEXION L'UTILISANT ET APPAREIL DE TERRAIN ÉQUIPÉ D'UN TEL DISPOSITIF DE CONNEXION

(30) Priorität: 16.05.2012 DE 102012104258
(43) Veröffentlichungstag der Anmeldung: 25.03.2015
(73) Patentinhaber: Endress+Hauser Flowtec AG, 4153 Reinach (BL) (CH)
(72) Erfinder: SIMON, Antoine, F-68300 St. Louis (FR); ROTH, Roland, CH-4242 Laufen (CH); BINDLER, Frantz, F-68320 Fortschwihr (FR)
(74) Vertreter: Andres, Angelika Maria
(86) Internationale Anmeldenummer: PCT/EP2013/058568
(87) Internationale Veröffentlichungsnummer: WO 2013/171046

(56) Entgegenhaltungen:
- EP-A1- 1 591 977
- DE-A1-102005 062 259
- DE-A1-102008 034 078
- DE-A1-102008 052 912

## Beschreibung

Die Erfindung betrifft einen Klemmenblock zum elektrischen Anschließen einer wenigstens zwei Adern aufweisenden Anschlußleitung sowie eine mit einem solchen Klemmenblock gebildete Anschlußvorrichtung zum elektrischen Verbinden einer in einem Elektronikgehäuse untergebrachten Schaltung eines Feldgeräts mit einer extern des Elektronikgehäuse verlegten Anschlußleitung. Ferner betrifft die Erfindung ein eine solche Anschlußvorrichtung umfassendes, beispielsweise als Meß- und/oder Schaltgerät ausgebildetes, Feldgerät.

In der industriellen Prozeß-Meßtechnik werden, insb. auch im Zusammenhang mit der Automation chemischer oder verfahrenstechnischer Prozesse und/oder der automatisierten Steuerung von industriellen Anlagen, sogenannte Feldgeräte, nämlich unmittelbar an der jeweiligen Anlage installierte elektrische Meß- und/oder Schaltgeräte, wie z.B. Coriolis-Massendurchfluß-Meßgeräte, Dichte-Meßgeräte, magnetisch-induktive Durchflußmeßgeräte, Wirbel-Durchflußmeßgeräte, Ultraschall-Durchflußmeßgeräte, thermische Massendurchfluß-Meßgeräte, Druck-Meßgeräte, Füllstand-Meßgeräte, Füllstandgrenzschalter, Temperatur-Meßgeräte, ph-Wert-Meßgeräte etc., eingesetzt, die der Erzeugung von Prozeßgrößen - analog oder beispielsweise auch digital - repräsentierenden Meßwerten sowie diese letztlich tragende Meßwertsignalen dienen. Bei den jeweils zu erfassenden Prozeßgrößen kann es sich je nach Anwendung beispielsweise, um einen Massendurchfluß, eine Dichte, eine Viskosität, einen Füll- oder einen Grenzstand, einen Druck oder eine Temperatur oder dergleichen, eines flüssigen, pulver-, dampf- oder gasförmigen Mediums handeln, das in einem entsprechenden Behälter, wie z.B. einer Rohrleitung oder einem Tank, geführt bzw. vorgehalten wird.

Zum Erfassen der jeweiligen Prozeßgrößen und zum Wandeln derselben in ein damit entsprechend korrespondierendes elektrisches Meßsignal weisen Feldgeräte jeweils einen entsprechenden physikalisch-elektrischen oder chemisch-elektrischen Meßaufnehmer auf, der zumeist unmittelbar in eine Wandung des das Medium jeweils führenden Behälters oder der in den Verlauf einer das Medium jeweils führenden Leitung, beispielsweise eine Rohrleitung, eingesetzt ist.

Zum Verarbeiten des Meßsignals ist der Meßaufnehmer weiters mit einer in einer Elektronik des Feldgeräts vorgesehenen, der Weiterverarbeitung oder Auswertung des wenigstens einen Meßsignals wie auch der Generierung entsprechender Meßwerte dienenden Meßgerät internen Betriebs- und Auswerteschaltung verbunden. Beispiele für derartige, dem Fachmann an und für sich bekannte Meßsysteme sind u.a. in der WO-A 88/02853, der WO-A 88/02476, der US-B 64 52 493, der US-A 2011/0317390, der EP-A 816 807, der EP-A 1 591 977 oder der DE-A 10 2008 052 912 gezeigt bzw. werden von der Anmelderin selbst, beispielsweise unter der Bezeichnung FLOWPHANT®T DTT31, t-switch ATT11, t-trend ATT12, Magphant DT1200, Promag 53H, Prowirl 73F, Promass 83X, oder Promass 84F, käuflich angeboten.

Die jeweilige Elektronik des jeweiligen Feldgeräts ist zumeist in einem vergleichsweise robusten, etwa schlag-, druck-, explosions- und/oder wetterfesten, Elektronik-Gehäuse untergebracht. Dieses kann z.B. vom Feldgerät entfernt angeordnet und mit diesem nur über eine flexible Leitung verbunden sein; es kann aber auch direkt am Meßaufnehmer oder an einem den Meßaufnehmer separat einhausenden Meßaufnehmer-Gehäuse angeordnet sein.

Bei einer Vielzahl von in der industriellen Meßtechnik verwendeten Feldgeräten mit Meßaufnehmer wird dieser zum Erzeugen des Meßsignals im Betrieb zudem von einem von der Betriebs- und Auswerteschaltung zumindest zeitweise generierten Treibersignal so angesteuert, daß er in einer für die Messung geeigneten Weise zumindest mittelbar oder aber auch über eine das Medium direkt kontaktierende Sonde praktisch unmittelbar auf das Medium einwirkt, um dort mit der zu erfassenden Meßgröße entsprechend korrespondierende Reaktionen hervorzurufen. Das Treibersignal kann dabei beispielsweise hinsichtlich einer Stromstärke, einer Spannungshöhe und/oder einer Frequenz entsprechend geregelt sein. Als Beispiele für solche aktiven, also ein elektrisches Treibersignal im Medium entsprechend umsetzende Meßaufnehmer sind im besonderen dem Messen von zumindest zeitweise strömenden Medien dienende Durchfluß-Meßaufnehmer, z.B. mit wenigstens einer vom Treibersignal angesteuerten, Magnetfeld erzeugenden Spule oder wenigstens einem vom Treibersignal angesteuerten Ultraschallsender, oder aber auch dem Messen und/oder Überwachen von Füllständen in einem Behälter dienende Füllstands- und/oder Grenzstandsaufnehmer, wie z.B. mit freistrahlender Mikrowellenantenne, mit Gouboun-Leitung oder mit vibrierendem Tauchkörper, zu nennen.

Die von der Betriebs- und Auswerteschaltung generierten Meßwerte werden an entsprechenden Schaltungsausgängen in Form von elektrischen - digitalen oder analogen - Meßwertsignalen bereitgestellt, beispielsweise in Form eines im Bereich von 4-20 mA entsprechend modulierten analogen Signalstroms. Darüberhinaus sind auch sogenannte Frequenzausgänge, nämlich die Meßwerte in eine Pulsfolgefrequenz eines binären Rechtecksignals codierende Schaltungsausgänge, oder auch sogenannte Impulsausgänge, nämlich das Erreichen einer vorab wählbaren, quantisierten Mengeneinheit in Form eines Impulses signalisierende Schaltungsausgänge, zur Bereitstellung von Meßwerten üblich. Neben vornehmlich dem Erfassen einer physikalischen dienenden Feldgeräten mit Meßaufnehmer gibt es zudem auch solche, beispielsweise als elektro-motorische Stellventile oder Pumpen ausgebildete, Feldgeräte die im besonderen dafür vorgesehen sind, einen oder mehrere physikalische Prozeßparameter einzustellen, mithin aktiv in den jeweiligen Prozeß einzugreifen, zusätzlich aber auch interne Meß- und/oder Einstellwerte an entsprechenden Schaltungsausgängen zur Verfügung stellen. Neben Meßwerte bereitstellenden Schaltungsausgängen der vorgenannten Art können moderne Feldgeräte gelegentlich auch sogenannte Status- bzw. Alarmausgänge und/oder auch dem unmittelbaren Ansteuern von an das Feldgerät direkt angeschlossenen externen elektrischen Geräten, mithin als Relais dienende Schaltausgänge aufweisen. Solche Schaltungsausgänge können als passiver, nämlich in einen von einer extern des Feldgeräts stationierten Spannungsquelle getriebenen Stromkreis eingeschleifter Schaltungsausgang oder auch als ein in einen von einer Feldgeräte internen Spannungsquelle getriebenen Stromkreis eingeschleifter aktiver Schaltungsausgang realisiert sein. Alternativ oder in Ergänzung könne Feldgeräte auch Schaltungsausgänge zum Anschließen eines, beispielsweise seriellen, Feldbusses aufweisen.

Zum Verbinden von internen elektronischen Schaltungen, nicht zuletzt auch von Schaltungsausgängen der eingangs erwähnten Art, mit einer oder mehrerer externer elektrischer Schaltungen weisen Feldgeräte zumeist mittels eines Klemmenblocks gebildete Anschlußeinrichtungen zum elektrischen Anschließen einer dem Feldgerät von extern zugeführten, zwei oder mehr Adern aufweisenden Anschlußleitung auf.

Feldgeräte der in Rede stehenden Art weisen gelegentlich einen oder mehrere elektrische Schaltungsausgänge auf, deren Funktionsweise bzw. deren elektrische Parameter, wie etwa eine jeweilige Ausgangsimpedanz bzw. ein jeweiliger Abschlußwiderstand, auch seitens des Anwenders bzw. vor Ort passend zur jeweiligen Anwendung konfiguriert werden können. Stellvertretend für solche konfigurierbaren Schaltungsausgänge von Feldgeräten sind beispielsweise die erwähnten, beispielsweise mittels eines Bipolar-Transistors mit "offenem" Kollektor-Anschluß (*open collector*) oder mittels eines Feldeffekt-Transistors mit "offenem" Drain-Anschluß (*open* drain)gebildeten, Schaltausgänge für binäre Schaltsignale oder auch Impulsausgänge binäre Taktsignale zu nennen. Im Regelfall müssen diese nämlich lediglich zwei hinsichtlich eines jeweils fließenden Stroms ausreichend separierte Schaltzustände aufweisen, also lediglich eine ausreichend große, möglichst gleichbleibende Differenz zwischen dem im Schaltzustand für logisch "0" (LOW) und dem im Schaltzustand für logisch "1" (HIGH) jeweils fließen gelassenen Strom bereitstellen. Für den besonderen Fall allerdings, daß nämlicher Schaltausgang etwa als ein zum Europäischen Standard EN 60947-5-6:2000 konformer passiver Schaltungsausgang konfiguriert werden soll, ist zudem auch sicherzustellen, daß bei den in nämlichem Standard normierten Anschlußbedingungen der im Schaltzustand für logisch "0" fließen gelassene Strom einen Strompegel, der innerhalb eines dafür vorgegebenen Intervalls von 0.1 mA bis 1 mA und der im Schaltzustand für logisch "1" fließen gelassene Strom einen Strompegel, der innerhalb eines vorgegebenen Stromintervalls von 2.2 mA bis 8 mA liegt, aufweisen. Dies kann beispielsweise dadurch erzielt werden, daß der zu nämlichem Standard konforme Schaltungsausgang zusätzlich einen den jeweils maximalen Strom begrenzenden Längswiderstand, beispielsweise in der Größenordnung von 1 kΩ, von dem ein erster Anschluß mit einer ersten Anschlußklemme des Klemmenblocks verbunden ist, sowie einen den jeweils minimalen Strom für logisch "0" sicherstellenden Querwiderstand, beispielsweise in der Größenordnung von 10 kΩ, von dem ein erster Anschluß entweder mit der ersten Anschlußklemme oder mit einem zweiten Anschluß des Längswiderstandes und eine zweiter Anschluß mit der zweiten Anschlußklemme verbunden sind, aufweist, welche beiden Widerstände ansonsten aber nicht vorzusehen sind.

Zwecks des Festlegens solcher Voreinstellungen oder Funktionen von Komponenten sind in konventionellen Feldgeräten zumeist Kurzschlußstecker zum selektiven Überbrücken von Schaltungselementen, sogenannte Jumper, oder auch sogenannte DIP-Schalter zum selektiven Schließen bzw. Auftrennen von Leitungspfaden der jeweiligen elektronischen Schaltungen vorgesehen, wobei nämliche Kurzschlußstecker bzw. DIP-Schalter, nicht zuletzt aus Platz - und Kostengründen zumeist in unmittelbarer Nähe zu der jeweils zu beschaltenden Komponenten, mithin unmittelbar auf einer die jeweilige Schaltung tragenden Leiteplatte und in unmittelbarer Nachbarschaft auch zu anderen Komponenten der elektronischen Schaltung angeordnet sind. Wenngleich derartige Individualisierungen von Schaltungsausgängen mittels Kurzschlußstecker bzw. DIP-Schalter zumeist nur einmal, etwa im Zuge des erstmaligen elektrischen Anschließen des jeweiligen Feldgeräts an eine externe Anschlußleitung, oder allenfalls nur sehr selten vorgenommen werden müssen, so ist damit dennoch ein nicht unerhebliches Risiko verbunden, die Elektronik dabei zu beschädigen, etwa durch elektrostatische Aufladung oder durch mechanische Einwirkungen.

Dem Rechnung tragend besteht eine Aufgabe der Erfindung darin, eine Anschlußeinrichung für einen Schaltungsausgang einer elektronischen Schaltung eines Feldgeräts bzw. einen Klemmenblock dafür bereitzustellen, womit ein Eingriff von außen in nämliche Schaltung zwecks eines Konfigurierens des Schaltungsausgangs, beispielsweise auch zwecks eines nachträglichen Konfigurierens vor Ort, zu einem mit dem Europäischen Standard EN 60947-5-6:2000 konformen Schaltungsausgang vermieden werden kann.

Zur Lösung der Aufgabe besteht die Erfindung in einem Klemmenblock zum elektrischen Anschließen einer, beispielsweise extern eines Elektronikgehäuse verlegten, wenigstens zwei Adern aufweisenden Anschlußleitung. Der erfindungsgemäße Klemmenblock umfaßt einen zumindest anteilig aus einem elektrisch isolierenden, beispielsweise eine einem Europäischen Standard EN 60947-1 genügende elektrische Spannungsfestigkeit aufweisenden, Kunststoff bestehenden Grundkörper, eine auf einer eine erste Anschlußseite des Klemmenblocks bildenden erste Seite des Grundkörpers angeordnete erste Anschlußklemme für eine erste Ader der Anschlußleitung, wenigstens eine auf der ersten Seite des Grundkörpers von der ersten Anschlußklemme seitlich beabstandet angeordnete zweite Anschlußklemme für eine zweite Ader der Anschlußleitung, eine auf einer eine zweite Anschlußseite des Klemmenblocks bildenden zweiten Seite des Grundkörpers angeordnete, beispielsweise als Kontaktstift oder als Kontaktbuchse ausgebildete, erste Anschlußelektrode, eine auf der zweiten Seite des Grundkörpers von der ersten Anschlußelektrode seitlich beabstandet angeordnete, beispielsweise als Kontaktstift oder als Kontaktbuchse ausgebildete, zweite Anschlußelektrode, ein innerhalb des Grundkörpers angeordnetes, beispielsweise auch in Kunststoff eingebettetes, erstes Widerstandselement, von dem ein erster Anschluß mit der ersten Anschlußklemme und ein zweiter Anschluß mit der ersten Anschlußelektrode elektrisch verbunden sind, sowie ein innerhalb des Grundkörpers angeordnetes, beispielsweise in Kunststoff eingebettetes, zweites Widerstandselement, von dem ein erster Anschluß mit der ersten Anschlußklemme oder mit der ersten Anschlußelektrode und ein zweiter Anschluß sowohl mit der zweiten Anschlußklemme als auch mit der zweiten Anschlußelektrode elektrisch verbunden sind.

Darüber hinaus besteht die Erfindung auch in einer Anschlußvorrichtung mit einem solchen Klemmenblock zum elektrischen Verbinden einer in einem Elektronikgehäuse untergebrachten Schaltung eines Feldgeräts mit einer extern des Elektronikgehäuse verlegten Anschlußleitung, wobei die erfindungsgemäße Anschlußvorrichtung neben nämlichem Klemmenblock einen zumindest anteilig aus einem elektrisch isolierenden Kunststoff bestehenden Anschlußsockel für den Klemmenblock umfaßt.

Ferner besteht die Erfindung in einem, beispielsweise als Meß- und/oder Schaltgerät ausgebildeten, Feldgerät mit einer solchen Anschlußvorrichtung sowie mit einer mit nämlicher Anschlußvorrichtung elektrisch verbundene elektronische Schaltung.

Nach einer ersten Ausgestaltung des Klemenblocks der Erfindung ist vorgesehen, daß das erste Widerstandselement einen ohmschen Widerstand von mehr als 0.9kΩ und weniger als 1.1 kΩ aufweist.

Nach einer zweiten Ausgestaltung des Klemenblocks der Erfindung ist vorgesehen, daß das zweite Widerstandselement einen ohmschen Widerstand von mehr als 9kΩ und weniger als 11kΩ aufweist.

Nach einer dritten Ausgestaltung des Klemenblocks der Erfindung ist vorgesehen, daß das zweite Widerstandselement einen ohmschen Widerstand aufweist, der mehr als einem 9-fachen eines ohmschen Widerstand des ersten Widerstandselements und weniger als einem 11-fachen des ohmschen Widerstand des ersten Widerstandselements entspricht.

Nach einer ersten Ausgestaltung der Anschlußvorrichtung der Erfindung weist der Anschlußsockel einen zumindest anteilig aus einem elektrisch isolierenden Kunststoff bestehenden Grundkörper, eine auf einer eine erste Anschlußseite des Anschlußsockels bildenden erste Seite des Grundkörpers angeordnete zur ersten Anschlußelektrode des Klemmenblocks komplementäre erste Anschlußelektrode, sowie wenigstens eine auf der ersten Seite des Grundkörpers von der ersten Anschlußelektrode seitlich beabstandet angeordnete angeordnete, zur zweiten Anschlußelektrode des Klemmenblocks komplementäre zweite Anschlußelektrode auf.

Nach einer zweiten Ausgestaltung der Anschlußvorrichtung der Erfindung ist vorgesehen, daß Anschlußsockel und Klemmenblock unter Bildung einer, als Steckkontakt ausgebildeten, galvanischen Verbindung zwischen der ersten Anschlußelektrode des Klemmenblocks und der ersten Anschlußelektrode des Anschlußsockels sowie zwischen der zweiten Anschlußelektrode des Klemmenblocks und der zweiten Anschlußelektrode des Anschlußsockels, beispielsweise auch wiederlösbar, miteinander mechanisch verbunden sind.

Nach einer dritten Ausgestaltung der Anschlußvorrichtung der Erfindung ist vorgesehen, daß jeder der zwei Anschlußelektroden des Anschlußsockels mit einer, beispielsweise als Leiterbahn auf einer Leiterplatte ausgebildeten, Leitung einer elektronischen Schaltung, beispielsweise stoffschlüssig, elektrisch verbunden ist.

Nach einer ersten Ausgestaltung des Feldgeräts der Erfindung ist vorgesehen, daß die elektronische Schaltung zwei, beispielsweise jeweils zumindest abschnittsweise als eine Leiterbahn auf einer Leiterplatte und/oder zumindest abschnittsweise als Leitungsdraht ausgebildete, Anschlußelektroden aufweist, von denen eine erste Anschlußelektrode mit der ersten Anschlußelektrode des Anschlußsockels und eine zweite Anschlußelektrode mit der zweiten Anschlußelektrode des Anschlußsockels, beispielsweise mittels Lötverbindung, elektrisch verbunden sind.

Nach einer zweiten Ausgestaltung des Feldgeräts der Erfindung ist vorgesehen, daß die elektronische Schaltung einen, beispielsweise mittels eines Transistors gebildeten und/oder passiven, Schaltungsausgang mit einer mit der ersten Anschlußelektrode des Anschlußsockels elektrisch verbundenen ersten Ausgangselektrode und mit einer mit der zweiten Anschlußelektrode des Anschlußsockels elektrisch verbundenen zweiten Ausgangselektrode aufweist. Diese Ausgestaltung der Erfindung weiterbildend ist ferner vorgesehen, daß mittels des Schaltungsausgangs, des Anschlußsockels und des Klemmenblocke ein zum Europäischen Standard EN 60947-5-6:2000 konformer Schaltausgang gebildet ist.

Nach einer dritten Ausgestaltung des Feldgeräts der Erfindung ist vorgesehen, daß die elektronische Schaltung einen Bipolar-Transistor mit einem Kollektor-Anschluß und mit einem Emitter-Anschluß aufweist. Diese Ausgestaltung der Erfindung weiterbildend ist ferner vorgesehen, daß, etwa zur Bildung eines zum Europäischen Standard EN 60947-5-6:2000 konformen Schaltausgangs, der Kollektor-Anschluß des Bipolar-Transistors mit der ersten Anschlußelektrode des Anschlußsockels, mithin via erstes Widerstandselement mit der ersten Anschlußklemme des Klemmenblocks, und der Emitter-Anschluß des Bipolar-Transistors mit der zweiten Anschlußelektrode des Anschlußsockels, mithin mit der zweiten Anschlußklemme des Klemmenblocks elektrisch verbundenen sind.

Nach einer vierten Ausgestaltung des Feldgeräts der Erfindung ist vorgesehen, daß die elektronische Schaltung einen Feldeffekt-Transistor mit einem Source-Anschluß und mit einem Drain-Anschluß aufweist. Diese Ausgestaltung der Erfindung weiterbildend ist ferner vorgesehen, daß, etwa zur Bildung eines zum Europäischen Standard EN 60947-5-6:2000 konformen Schaltausgangs, der Drain-Anschluß des Feldeffekt-Transistors mit der ersten Anschlußelektrode des Anschlußsockels, mithin via erstes Widerstandselement mit der ersten Anschlußklemme des Klemmenblocks, und der Source-Anschluß des Feldeffekt-Transistors mit der zweiten Anschlußelektrode des Anschlußsockels, mithin mit der zweiten Anschlußklemme des Klemmenblocks elektrisch verbundenen sind.

Nach einer ersten Weiterbildung des Feldgeräts der Erfindung umfaßt dieses weiters ein Elektronikgehäuse, innerhalb dem sowohl die Anschlußvorrichtung als auch die elektronische Schaltung untergebracht sind.

Nach einer zweiten Weiterbildung des Feldgeräts der Erfindung umfaßt dieses weiters einen Meßaufnehmer zum Erzeugen wenigstens eines von einer zu erfassenden physikalischen Meßgröße abhängigen Meßsignals.

Ein Grundgedanke der Erfindung besteht darin, für die Konfigurierung von Schaltungsausgängen elektronischer Schaltungen von Feldgeräten gelegentlich, etwa zur Bildung eines mit dem Europäischen Standard EN 60947-5-6:2000 konformen Schaltungsausgang, erforderliche zusätzliche, nämlich mittels Kurzschlußstecker bzw. DIP-Schalter zu- bzw. abschaltbare, Widerstände nicht wie bisher unmittelbar auf einer Leiterplatten anzuordnen, die die jeweilige elektronische Schaltung bzw. die deren Ausgang bildenden elektronischen Komponenten trägt, sondern davon abgesetzt in einem via Anschlußsockel lösbar mit den übrigen Komponenten der elektronischen Schaltung verbunden speziellen Klemmenblock unterzubringen. Ein Vorteil der Erfindung ist u.a. darin zu sehen, daß nämlicher Klemmenblock wiederum sehr einfach gegen einen anderen Klemmenblock, ggf. auch einen Klemmenblock ohne Widerstände oder einen Klemmenblock mit andere Widerstandswerte aufweisenden Widerständen, ausgetauscht werden kann, beispielsweise auch bei bereits vor Ort installiertem Feldgerät, oder umgekehrt, etwa im Falle daß erst nach Installation des Feldgeräts eine Konfigurierung des Schaltungsausgangs gemäß dem Europäischen Standard EN 60947-5-6:2000 erforderlich wird, nämlicher Schaltungsausgangs mittels eines die entsprechende Widerstände in sich bergende speziellen Klemmenblock sehr einfach nachgerüstet werden kann.

Die Erfindung sowie weitere vorteilhafte Ausgestaltungen davon werden nachfolgend anhand von Ausführungsbeispielen näher erläutert, die in den Figuren der Zeichnung dargestellt sind. Gleiche Teile sind in allen Figuren mit denselben Bezugszeichen versehen; wenn es die Übersichtlichkeit erfordert oder es anderweitig sinnvoll erscheint, wird auf bereits erwähnte Bezugszeichen in nachfolgenden Figuren verzichtet. Weitere vorteilhafte Ausgestaltungen oder Weiterbildungen, insb. auch Kombinationen zunächst nur einzeln erläuterter Teilaspekte der Erfindung, ergeben sich ferner aus den Figuren der Zeichnung wie auch den Unteransprüchen an sich. Im einzelnen zeigen:
- Fig. 1: schematisch ein, beispielsweise als industrielles Meß- und/oder Schaltgerät ausgebildetes, Feldgerät;
- Fig. 2: schematisch eine Variante eines für das Feldgerät nach Fig. 1 geeigneten Klemmenblocks; und
- Fig. 3: schematisch eine Variante eines für das Feldgerät nach Fig. 1 geeigneten Schaltungsausgangs.

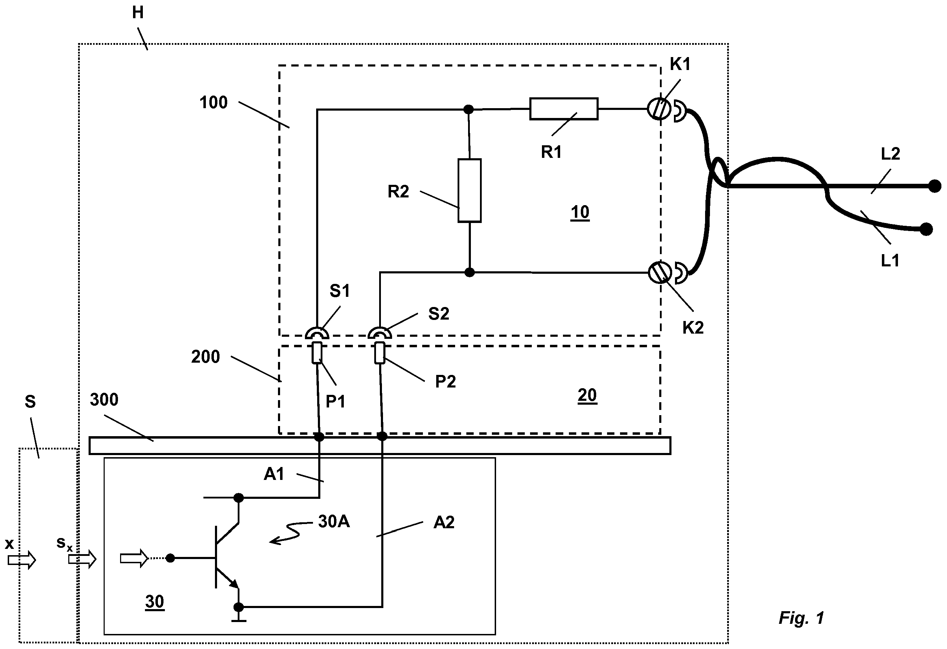

In der Fig. 1 ist schematisch ein Feldgerät mit einer innerhalb eines Elektronikgehäuses H untergebrachten elektronischen, nämlich zumindest anteilig mittels Halbleiterelementen gebildeten, Schaltung 30 dargestellt. Das Feldgerät kann beispielsweise als ein für die industrielle Automatisierungstechnik geeignetes, Meß- und/oder Schaltgerät ausgebildet sein und/oder, wie in der Figur angedeutet, einen an die Schaltung 30 angeschlossenen, dem Erzeugen wenigstens eines von einer zu erfassenden physikalischen Meßgröße x abhängigen Meßsignals sₓ dienenden Meßaufnehmer S aufweisen.

Die elektronische Schaltung 30 weist einen, beispielsweise mittels eines Transistors gebildeten, Schaltungsausgang 30A mit einer ersten Ausgangselektrode A1 und mit einer zweiten Ausgangselektrode A2 auf. Jede der zwei Ausgangselektroden A1, A2 kann z.B. jeweils zumindest abschnittsweise als eine Leiterbahn auf einer die elektronische Schaltung 30 zumindest anteilig tragenden Leiterplatte 300 und/oder zumindest abschnittsweise als Leitungsdraht ausgebildet sein. Schaltungsausgang wiederum kann beispielsweise ein Frequenzausgang zum Ausgeben eines binären Rechtecksignals mit einer die Meßgröße x bzw. deren zeitlichen Verlauf repräsentierende Meßwerte codierenden Pulsfolgefrequenz oder beispielsweise ein Impulsausgang zum Ausgeben von Impulsen, die das Erreichen einer vorab wählbaren, quantisierten Mengeneinheit der Meßgröße x signalisieren, sein. Der Schaltungsausgang kann aber beispielsweise auch als Status- oder eine Alarmausgang und/oder auch dem unmittelbaren Ansteuern von an das Feldgerät direkt angeschlossenen externen elektrischen Geräten, mithin als ein Relais dienender, beispielsweise auch passiver, Schaltausgang konfiguriert sein oder aber auch als Anschluß für einen, beispielsweise seriellen, Feldbus eingerichtet sein.

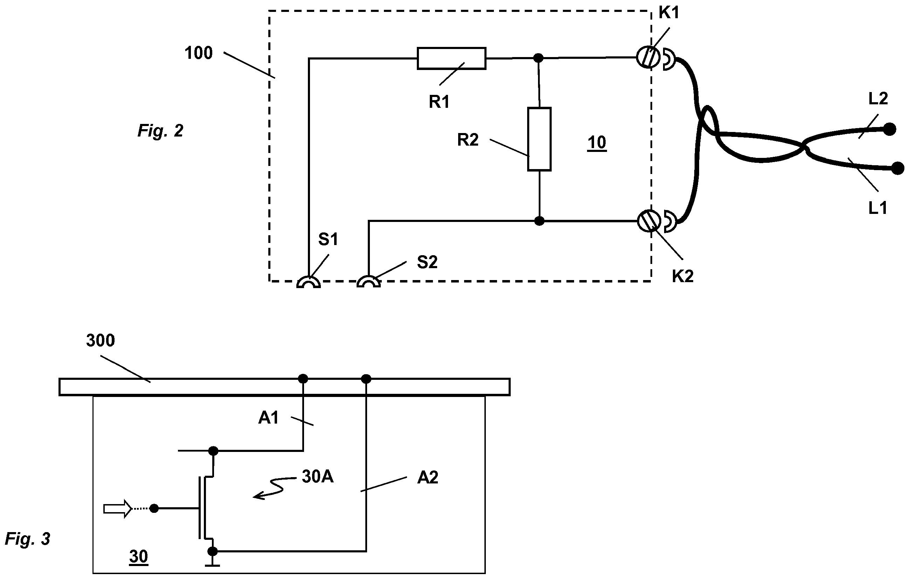

Im in Fig. 1 gezeigten Ausführungsbeispiel ist der Schaltungsausgang 30A, beispielsweise zwecks Bildung eines *Open-Collector*-Ausgangs, mittels eines Bipolar-Transistors gebildet, wobei ein Kollektor-Anschluß des Bipolar-Transistors die Anschlußelektrode A1 der elektronischen Schaltung 30 und ein Emitter-Anschluß des Bipolar-Transistors die Anschlußelektrode A2 der elektronischen Schaltung 30 bilden. Alternativ oder in Ergänzung kann der Schaltungsausgang 30A, wie in Fig. 2 schematisch dargestellt, beispielsweise auch mittels eines Feldeffekt-Transistors mit einem Source-Anschluß und mit einem Drain-Anschluß gebildet sein, beispielsweise derart, daß, unter Bildung eines Open-Drain-Ausgangs, die erste Anschlußelektrode A1 der elektronischen Schaltung 30 mittels des Drain-Anschlußes und die zweite Anschlußelektrode A2 der elektronischen Schaltung 30 mittels des Source-Anschlußes gebildet sind.

Zum elektrischen Verbinden des Schaltungsausgangs 30A, mithin der elektronischen Schaltung 30 mit einer extern des Elektronikgehäuse H verlegten Anschlußleitung ist im Feldgerät ferner eine mit der Schaltung 30 elektrisch verbundene Anschlußvorrichtung mit einem Klemmenblock 10 für eine solche Anschlußleitung sowie einem zumindest anteilig aus einem elektrisch isolierenden Kunststoff bestehenden Anschlußsockel 20 für den Klemmenblock vorgesehen.

Der Klemmenblock 10 weist einen zumindest anteilig aus einem elektrisch isolierenden, beispielweise auch eine einem Europäischen Standard EN 60947-1 genügende elektrische Spannungsfestigkeit aufweisenden, Kunststoff bestehenden Grundkörper 100 auf. Auf einer eine erste Anschlußseite des Klemmenblocks 10 bildenden ersten Seite des Grundkörpers 100 sind eine erste Anschlußklemme K1 für eine erste Ader L1 einer Anschlußleitung sowie, von der ersten Anschlußklemme seitlich beabstandet, wenigstens eine zweite Anschlußklemme K2 für eine zweite Ader L2 der Anschlußleitung angeordnet. Auf einer eine zweite Anschlußseite des Klemmenblocks 10 bildenden zweiten Seite des Grundkörpers sind zudem eine, beispielsweise als Kontaktstift oder als Kontaktbuchse ausgebildete, erste Anschlußelektrode S1 sowie, von der ersten Anschlußelektrode seitlich beabstandet, eine, beispielsweise als Kontaktstift oder als Kontaktbuchse ausgebildete, zweite Anschlußelektrode S2 angeordnet.

Der praktisch ein Gegenstück zum Klemmenblock 10 bildende Anschlußsockel 20 weist ebenfalls einen zumindest anteilig aus einem elektrisch isolierenden Kunststoff, beispielsweise auch demselben Kunststoff wie der Grundkörper 100 des Klemmenblocks 10, bestehenden Grundkörper 200 auf. Auf einer eine erste Anschlußseite des Anschlußsockels 20 bildenden ersten Seite des Grundkörpers 200 sind daher eine zur Anschlußelektrode S1 des Klemmenblocks 10 komplementäre erste Anschlußelektrode P1 sowie, von nämlicher Anschlußelektrode P1 seitlich beabstandet, eine entsprechend zur Anschlußelektrode S2 des Klemmenblocks 10 komplementäre Anschlußelektrode P2 angeordnet. Jede der zwei Anschlußelektroden P1, P2 des Anschlußsockels kann, wie in Fig. 1 schematisch dargestellt, jeweils unmittelbar mit der jeweils komplementären, beispielsweise als Leiterbahn auf einer Leiterplatte 300 ausgebildeten, Ausgangselektrode A1 bzw. A2 der elektronischen Schaltung 30 elektrisch verbunden sein, beispielsweise mittels stoffschlüssiger Lötverbindung.

Im besonderen sind Klemmenblock 10 und Anschlußsockel 20 ferner dafür eingerichtet unter Bildung einer, beispielsweise als Steckkontakt ausgebildeten, galvanischen Verbindung zwischen der Anschlußelektrode S1 des Klemmenblocks 10 und der dazu komplementären Anschlußelektrode P1 des Anschlußsockels 20 sowie zwischen der Anschlußelektrode S2 des Klemmenblocks 10 und der dazu komplementären Anschlußelektrode P2 des Anschlußsockels 20, insb. wiederlösbar, miteinander mechanisch verbunden werden zu können bzw. entsprechend miteinander verbunden zu sein.

Für den erwähnten Fall, daß der Schaltungsausgang 30A mittels eines Bipolar-Transtors gebildete ist, so daß die Anschlußelektrode A1 mittels eines Kollektor-Anschlußes und die Anschlußelektrode A2 mittels eines Emitter-Anschluß gebildet sind, sind im Ergebnis, wie auch aus der Fig. 1 ohne weiteres ersichtlich, der Kollektor-Anschluß des Bipolar-Transistors mit der Anschlußelektrode P1 des Anschlußsockels, mithin via erstes Widerstandselement R1 mit der Anschlußklemme K1 des Klemmenblocks, bzw. der Emitter-Anschluß des Bipolar-Transistors mit der Anschlußelektrode P2 des Anschlußsockels, mithin mit der Anschlußklemme K2 des Klemmenblocks elektrisch verbundenen sind. Für den anderen erwähnten Fall, daß der Schaltungsausgang 30A mittels eines Feldeffekt-Transistors gebildet ist, so daß die Anschlußelektrode A1 mittels eines Drain-Anschlußes und die Anschlußelektrode A2 mittels eines Source-Anschluß gebildet sind, sind im Ergebnis, wie auch aus der Fig. 3 ohne weiteres ersichtlich, der Drain-Anschluß des Feldeffekt-Transistors mit der Anschlußelektrode P1 des Anschlußsockels, mithin via Widerstandselement R1 mit der Anschlußklemme K1 des Klemmenblocks, bzw. der Source-Anschluß des Feldeffekt-Transistors mit der Anschlußelektrode P2 des Anschlußsockels, mithin mit der Anschlußklemme K2 des Klemmenblocks elektrisch verbundenen.

Beim erfindungsgemäßen Klemmblock 10 bzw. der damit gebildeten Anschlußeinrichtung, mithin bei dem damit gebildeten Feldgerät, sind innerhalb des Grundkörpers 100 ein erstes Widerstandselement R1 sowie ein zweites Widerstandselement R2 angeordnet. Nicht zuletzt zwecks des Bildens eines zum eingangs erwähnten Europäischen Standard EN 60947-5-6:2000 konformen Schaltausgangs sind, wie in der Fig. 1 schematisiert dargestellt, ein erster Anschluß des, beispielsweise auch in elektrisch isolierenden Kunststoff eingebetteten, Widerstandselements R1 mit der Anschlußklemme K1 des Klemmenblocks 100 und ein zweiter Anschluß nämlichen Widerstandselements R1 mit der Anschlußelektrode S1 des Klemmenblocks 100 elektrisch verbunden. Desweiteren ist ein erster Anschluß des, beispielsweise ebenfalls in elektrisch isolierenden Kunststoff eingebetteten, Widerstandselements R2, wie in Fig. 1 schematisch dargestellt, mit der Anschlußklemme K1 oder, wie in Fig. 3 schematisch dargestellt, mit der Anschlußelektrode S1 des Klemmenblocks 100 verbunden, während ein zweiter Anschluß des Widerstandselements R2 sowohl mit der Anschlußklemme K2 als auch mit der Anschlußelektrode S2 des Klemmenblocks 100 elektrisch verbunden ist. Im Ergebnis bilden das Widerstandselement R1 praktisch einen den im Betrieb durch die Anschlußklemmen K1, K2, mithin im Schaltungsausgang 30A fließenden Strom begrenzenden Längswiderstand und das Widerstandselement R2 dementsprechend einen im Betrieb einen permanenten Stromfluß im Schaltungsausgang 30A ermöglichenden Querwiderstand.

Gemäß einer Ausgestaltung der Erfindung weist das Widerstandselement R1 einen ohmschen Widerstand von mehr als 0.9kΩ und weniger als 1.1kQ auf und/oder weist das Widerstandselement R2 einen ohmschen Widerstand von mehr als 9kQ und weniger als 11kΩ auf. Alternativ oder in Ergänzung sind der ohmsche Widerstand des ersten Widerstandselements und der ohmsche Widerstand des zweiten Widerstandselements gemäß einer weiteren Ausgestaltung der Erfindung, nicht zuletzt auch zwecks Gewährleistung der im Europäischen Standard EN 60947-5-6:2000 geforderten Strompegel für logisch "0" bzw. logisch "1" entsprechenden Schaltzustände, so gewählt, daß im Ergebnis das Widerstandselement R2 einen ohmschen Widerstand aufweist, der mehr als einem 9-fachen eines ohmschen Widerstands des Widerstandselements R1 und weniger als einem 11-fachen des ohmschen Widerstands des Widerstandselements R1 entspricht.

## Patentansprüche

1. Klemmenblock (10) zum elektrischen Anschließen einer, insb. extern eines Elektronikgehäuse (H) verlegten, wenigstens zwei Adern (L1, L2) aufweisenden Anschlußleitung, welcher Klemmenblock umfaßt:
- einen zumindest anteilig aus einem elektrisch isolierenden, insb. eine einem Europäischen Standard EN 60947-1 genügende elektrische Spannungsfestigkeit aufweisenden, Kunststoff bestehenden Grundkörper (100);
- eine auf einer eine erste Anschlußseite des Klemmenblocks (10) bildenden erste Seite des Grundkörpers (100) angeordnete erste Anschlußklemme (K1) für eine erste Ader (L1) der Anschlußleitung;
- wenigstens eine auf der ersten Seite des Grundkörpers (100) von der ersten Anschlußklemme seitlich beabstandet angeordnete zweite Anschlußklemme (K2) für eine zweite Ader (L2) der Anschlußleitung;
- eine auf einer eine zweite Anschlußseite des Klemmenblocks (10) bildenden zweiten Seite des Grundkörpers (100) angeordnete, insb. als Kontaktstift oder als Kontaktbuchse ausgebildete, erste Anschlußelektrode (S1);
- eine auf der zweiten Seite des Grundkörpers (100) von der ersten Anschlußelektrode seitlich beabstandet angeordnete, insb. als Kontaktstift oder als Kontaktbuchse ausgebildete, zweite Anschlußelektrode (S2);
- ein innerhalb des Grundkörpers (100) angeordnetes, insb. in Kunststoff eingebettetes, erstes Widerstandselement (R1), von dem ein erster Anschluß mit der ersten Anschlußklemme (K1) und ein zweiter Anschluß mit der ersten Anschlußelektrode (S1) elektrisch verbunden sind; sowie
- ein innerhalb des Grundkörpers (100) angeordnetes, insb. in Kunststoff eingebettetes, zweites Widerstandselement (R2), von dem ein erster Anschluß mit der ersten Anschlußklemme (K1) oder mit der ersten Anschlußelektrode (S1) und ein zweiter Anschluß sowohl mit der zweiten Anschlußklemme (K2) als auch mit der zweiten Anschlußelektrode (S2) elektrisch verbunden sind.

2. Klemmenblock nach Anspruch 1,
- wobei das erste Widerstandselement (R1) einen ohmschen Widerstand von mehr als 0.9kQ und weniger als 1.1kΩ aufweist; und/oder
- wobei das zweite Widerstandselement (R2) einen ohmschen Widerstand von mehr als 9kΩ und weniger als 11kΩ aufweist; und/oder
- wobei das zweite Widerstandselement (R2) einen ohmschen Widerstand aufweist, der mehr als einem 9-fachen eines ohmschen Widerstand des ersten Widerstandselements (R1) und weniger als einem 11-fachen des ohmschen Widerstand des ersten Widerstandselements (R1) entspricht.

3. Anschlußvorrichtung (10, 20) zum elektrischen Verbinden einer in einem Elektronikgehäuse (H) untergebrachten Schaltung eines Feldgeräts mit einer extern des Elektronikgehäuse verlegten Anschlußleitung (L1, L2), welche Anschlußvorrichtung einen Klemmenblock (10) nach einem der vorherigen Ansprüche sowie einen zumindest anteilig aus einem elektrisch isolierenden Kunststoff bestehenden Anschlußsockel (20) für den Klemmenblock umfaßt.

4. Anschlußvorrichtung nach Anspruch 3, wobei der Anschlußsockel (20)
- einen zumindest anteilig aus einem elektrisch isolierenden Kunststoff bestehenden Grundkörper (200);
- eine auf einer eine erste Anschlußseite des Anschlußsockels bildenden erste Seite des Grundkörpers angeordnete zur ersten Anschlußelektrode (S1) des Klemmenblocks komplementäre erste Anschlußelektrode (P1); sowie
- wenigstens eine auf der ersten Seite des Grundkörpers von der ersten Anschlußelektrode seitlich beabstandet angeordnete, zur zweiten Anschlußelektrode (S2) des Klemmenblocks komplementäre zweite Anschlußelektrode (P2) aufweist.

5. Anschlußvorrichtung nach dem vorherigen Anspruch,
- wobei Anschlußsockel (20) und Klemmenblock (10) unter Bildung einer, als Steckkontakt ausgebildeten, galvanischen Verbindung zwischen der ersten Anschlußelektrode (S1) des Klemmenblocks (10) und der ersten Anschlußelektrode (P1) des Anschlußsockels sowie zwischen der zweiten Anschlußelektrode (S2) des Klemmenblocks (10) und der zweiten Anschlußelektrode (P2) des Anschlußsockels, insb. wiederlösbar, miteinander mechanisch verbunden sind; und/oder
- wobei jede der zwei Anschlußelektroden (P1, P2) des Anschlußsockels (20) jeweils mit einer, insb. als Leiterbahn auf einer Leiterplatte (300) ausgebildeten, Leitung einer elektronischen Schaltung (30), insb. stoffschlüssig, elektrisch verbunden ist.

6. Feldgerät, insb. Meß- und/oder Schaltgerät, umfassend:
- eine Anschlußvorrichtung (10, 20) nach einem der Ansprüche 3 bis 5;
- sowie eine mit nämlicher Anschlußvorrichtung elektrisch verbundene elektronische Schaltung (30).

7. Feldgerät nach Anspruch 6, wobei die elektronische Schaltung (30) zwei, insb. jeweils zumindest abschnittsweise als eine Leiterbahn auf einer Leiterplatte (300) und/oder zumindest abschnittsweise als Leitungsdraht ausgebildete, Anschlußelektroden (A1, A2) aufweist, von denen eine erste Anschlußelektrode (A1) mit der ersten Anschlußelektrode (P1) des Anschlußsockels (20) und eine zweite Anschlußelektrode (A2) mit der zweiten Anschlußelektrode (P2) des Anschlußsockels (20), insb. mittels Lötverbindung, elektrisch verbunden sind.

8. Feldgerät nach einem der Ansprüche 6 bis 7, weiters umfassend: ein Elektronikgehäuse (H), wobei sowohl die Anschlußvorrichtung (10, 20) als auch die elektronische Schaltung (30) innerhalb des Elektronikgehäuses (H) untergebracht sind.

9. Feldgerät nach einem der Ansprüche 6 bis 8, weiters umfassend: einen Meßaufnehmer (S) zum Erzeugen wenigstens eines von einer zu erfassenden physikalischen Meßgröße (x) abhängigen Meßsignals (sₓ).

10. Feldgerät nach einem der Ansprüche 6 bis 9, wobei die elektronische Schaltung einen, insb. mittels eines Transistors gebildeten und/oder passiven, Schaltungsausgang (30A) mit einer mit der ersten Anschlußelektrode (P1) des Anschlußsockels (20) elektrisch verbundenen ersten Ausgangselektrode (A1) und mit einer mit der zweiten Anschlußelektrode (P2) des Anschlußsockels (20) elektrisch verbundenen zweiten Ausgangselektrode (A2) aufweist; insb. derart, daß mittels des Schaltungsausgangs, des Anschlußsockels (20) und des Klemmenblocks (10) ein zum Europäischen Standard EN 60947-5-6:2000 konformer Schaltausgang gebildet ist.

11. Feldgerät nach einem der Ansprüche 6 bis 10, wobei die elektronische Schaltung einen Bipolar-Transistor mit einem, insb. die erste Anschlußelektrode (A1) der elektronischen Schaltung (30) bildenden, Kollektor-Anschluß und mit einem, insb. die zweite Anschlußelektrode (A2) der elektronischen Schaltung (30) bildenden, Emitter-Anschluß aufweist.

12. Feldgerät nach Anspruch 11, wobei, insb. zur Bildung eines zum Europäischen Standard EN 60947-5-6:2000 konformen Schaltausgangs,
- der Kollektor-Anschluß des Bipolar-Transistors mit der ersten Anschlußelektrode (P1) des Anschlußsockels, mithin via erstes Widerstandselement (R1) mit der ersten Anschlußklemme (K1) des Klemmenblocks, und
- der Emitter-Anschluß des Bipolar-Transistors mit der zweiten Anschlußelektrode (P2) des Anschlußsockels, mithin mit der zweiten Anschlußklemme (K2) des Klemmenblocks elektrisch verbundenen sind.

13. Feldgerät nach einem der Ansprüche 6 bis 11, wobei die elektronische Schaltung einen Feldeffekt-Transistor mit einem, insb. die erste Anschlußelektrode der elektronischen Schaltung bildenden, Drain-Anschluß und mit einem, insb. die zweite Anschlußelektrode der elektronischen Schaltung bildenden, Source-Anschluß aufweist.

14. Feldgerät nach Anspruch 13, wobei, insb. zur Bildung eines zum Europäischen Standard EN 60947-5-6:2000 konformen Schaltausgangs,
- der Drain-Anschluß des Feldeffekt-Transistors mit der ersten Anschlußelektrode des Anschlußsockels, mithin via erstes Widerstandselement mit der ersten Anschlußklemme des Klemmenblocks, und
- der Source-Anschluß des Feldeffekt-Transistors mit der zweiten Anschlußelektrode des Anschlußsockels, mithin mit der zweiten Anschlußklemme des Klemmenblocks elektrisch verbundenen sind.

## Claims

1. Terminal block (10) designed for the electrical connection of a connection cable comprising at least two wires (L1, L2), said cable being particularly routed outside an electronics housing (H), said terminal block comprising:
- a meter body (100) made at least in part from a plastic that is electrically insulating, particularly having a dielectric strength that meets the European Standard EN 60947-1;
- a first terminal (K1) arranged on a first side of the meter body (100) forming a first connection side of the terminal block (10), said first terminal being designed for a first wire (L1) of the connection cable;
- at least a second terminal (K2) arranged on the first side of the meter body (100), arranged at a lateral distance from the first terminal, said second terminal being designed for a second wire (L2) of the connection cable ;
- a first connection electrode (S1), arranged on a second side of the meter body (100) forming a second connection side of the terminal block (10), particularly designed as a male contact element or as a female contact element;
- a second connection electrode (S2), arranged on the second side of the meter body (100), arranged at a lateral distance from the first connection electrode, said second electrode being particularly designed as a male contact element or as a female contact element;
- a first resistance element (R1) arranged inside the meter body (100), particularly embedded in plastic, wherein a first connection of said resistance element is electrically connected to the first terminal (K1) and a second connection is electrically connected to the first connection electrode (S1), and
- a second resistance element (R2) arranged inside the meter body (100), particularly embedded in plastic, wherein a first connection of said resistance element is electrically connected to the first terminal (K1) or to the first connection electrode (S1), and a second connection is simultaneously connected to both the second terminal (K2) and to the second connection electrode (S2).

2. Terminal block as claimed in Claim 1,
- wherein the first resistance element (R1) has an ohmic resistance of more than 0.9 kΩ and less than 1.1 kΩ; and/or
- wherein the second resistance element (R2) has an ohmic resistance of more than 9 kΩ and less than 11 kΩ; and/or
- wherein the second resistance element (R2) has an ohmic resistance that corresponds to more than 9 times an ohmic resistance of the first resistance element (R1) and less than 11 times the ohmic resistance of the first resistance element (R1).

3. Connection apparatus (10, 20) for the electrical connection of a circuit of a field device accommodated in an electronics housing (H) with a connection cable (L1, L2) routed externally from the electronics housing, said connection apparatus comprising a terminal block (10) as claimed in one of the previous claims, as well as a connecting base (20) for the terminal block, said base being made at least in part from an electrically insulating plastic.

4. Connection apparatus as claimed in Claim 3, wherein the connecting base (20) features
- a meter body (200) consisting at least in part of an electrically insulating plastic;
- a first connection electrode (P1) arranged on a first side of the meter body forming a first connection side of the connecting base, said connection electrode (P1) being complementary to the first connection electrode (S1) of the terminal block; and
- at least a second connection electrode (P2) arranged on the first side of the meter body, arranged at a lateral distance from the first connection electrode, said connection electrode (P2) being complementary to the second connection electrode (S2) of the terminal block.

5. Connection apparatus as claimed in the previous claim,
- wherein the connecting base (20) and the terminal block (10) are interconnected mechanically, particularly in a detachable manner, forming a galvanic connection, particularly designed as a male contact element, between the first connection electrode (S1) of the terminal block (10) and the first connection electrode (P1) of the connecting base, as well as between the second connection electrode (S2) of the terminal block (10) and the second connection electrode (P2) of the connecting base; and/or
- wherein each of the two connection electrodes (P1, P2) of the connecting base (20) is connected electrically, particularly by means of a material bond, with a conductor of an electronic circuit (30), said conductor being particularly designed as a conductive track on a printed circuit board (300).

6. Field device, particularly a measuring device and/or a switching device, comprising:
- a connection apparatus (10, 20) as claimed in one of the Claims 3 to 5;
- as well as an electronic circuit (30) connected electrically to said connection apparatus.

7. Field device as claimed in Claim 6, wherein the electronic circuit (30) has two connection electrodes (A1, A2), each being particularly designed at least as a conductive track on a printed circuit board (300) and/or at least partially as a conducting wire, wherein of said electrodes a first connection electrode (A1) is connected electrically to the first connection electrode (P1) of the connecting base (20) and a second connection electrode (A2) is connected to the second connection electrode (P2) of the connecting base (20), particularly by means of a solder connection.

8. Field device as claimed in one of the Claims 6 to 7, further comprising: an electronics housing (H), wherein both the connection apparatus (10, 20) and the electronic circuit (30) are accommodated inside the electronics housing (H).

9. Field device as claimed in one of the Claims 6 to 8, further comprising: a sensor (S) for the generation of at least one measuring signal (sₓ) that depends on a physical measured variable (x) to be measured.

10. Field device as claimed in one of the Claims 6 to 9, wherein the electronic circuit has a circuit output (30A), particularly formed with a transistor and/or a passive output, with a first output electrode (A1) connected electrically to the first connection electrode (P1) of the connecting base and with a second output electrode (A2) connected electrically to the second connection electrode (P2) of the connecting base, particularly in such a way that a switch output that complies with European Standard EN 60947-5-6:2000 is formed with the circuit output, the connecting base (20) and the terminal block (10).

11. Field device as claimed in one of the Claims 6 to 10, wherein the electronic circuit features a bipolar transistor with a collector connection particularly forming the first connection electrode (A1) of the electronic circuit (30), and with an emitter connection particularly forming the second connection electrode (A2) of the electronic circuit (30).

12. Field device as claimed in Claim 11, wherein, particularly with aim of creating a switch output that complies with European Standard EN 60947-5-6:2000
- the collector connection of the bipolar transistor is connected electrically to the first connection electrode (P1) of the connecting base, and consequently via the first resistance element (R1) with the first terminal (K1) of the terminal block, and
- the emitter connection of the bipolar transistor is connected electrically to the second connection electrode (P2) of the connecting base, and consequently to the second terminal (K2) of the terminal block.

13. Field device as claimed in one of the Claims 6 to 11, wherein the electronic circuit has a field effect transistor with a drain connection particularly forming the first connection electrode of the electronic circuit, and with a source connection particularly forming the second connection electrode of the electronic circuit.

14. Field device as claimed in Claim 13, wherein, particularly with aim of creating a switch output that complies withe European Standard EN 60947-5-6:2000,
- the drain connection of the field effect transistor is connected electrically to the first connection electrode of the connecting base, and consequently via the first resistance element to the first terminal of the terminal block, and
- the source connection of the field effect transistor is connected electrically to the second connection electrode of the connecting base, and consequently to the second terminal of the terminal block.

## Revendications

1. Bornier (10) destiné au raccordement électrique d'un câble de raccordement comportant au moins deux conducteurs (L1, L2), notamment disposés à l'extérieur d'un boîtier électronique (H), lequel bornier comprend :
- un corps de base (100) constitué de plastique, présentant une résistance à la tension électrique, notamment répondant à la norme européenne EN 60947-1 ;
- une première borne de raccordement (K1) disposée sur une première face du corps formant un premier côté de raccordement du bornier (10), laquelle première borne de raccordement est destinée à un premier conducteur (L1) du câble de raccordement ;
- au moins une deuxième borne de raccordement (K2) disposée sur le premier côté du corps (100), espacée latéralement de la première borne de raccordement, laquelle deuxième borne de raccordement est destinée à un deuxième conducteur (L2) du câble de raccordement ;
- une première électrode de raccordement (S1), disposée sur un deuxième côté du corps de base (100) formant un deuxième côté de raccordement du bornier (10), notamment conçue en tant qu'élément de contact mâle ou en tant qu'élément de contact femelle ;
- une deuxième électrode de raccordement (S2), disposée sur le deuxième côté du corps de base (100), espacée latéralement de la première électrode de raccordement, laquelle deuxième électrode est notamment conçue en tant qu'élément de contact mâle ou en tant qu'élément de contact femelle ;
- un premier élément résistif (R1) disposé à l'intérieur du corps de base (100), notamment enrobé dans du plastique, élément résistif duquel une première connexion est reliée électriquement avec la première borne de raccordement (K1) et une deuxième connexion avec la première électrode de raccordement (S1), ainsi que
- un deuxième élément résistif (R2) disposé à l'intérieur du corps de base (100), notamment enrobé dans du plastique, élément résistif duquel une première connexion est reliée électriquement avec la première borne de raccordement (K1) ou avec la première électrode de raccordement (S1), et une deuxième connexion à la fois avec la deuxième borne de raccordement (K2) et avec la deuxième électrode de raccordement (S2).

2. Bornier selon la revendication 1,
- pour lequel le premier élément résistif (R1) présente une résistance ohmique de plus de 0,9 kΩ et de moins de 1,1 kΩ ; et/ou
- pour lequel le deuxième élément résistif (R2) présente une résistance ohmique de plus de 9 kΩ et de moins de 11 kΩ ; et/ou
- pour lequel le deuxième élément résistif (R2) présente une résistance ohmique, qui correspond à plus de 9 fois à une résistance ohmique du premier élément résistif (R1) et à moins de 11 fois à une résistance ohmique du premier élément résistif (R1).

3. Dispositif de raccordement (10, 20) destiné au raccordement électrique d'un circuit d'un appareil de terrain logé dans un boîtier électronique (H) avec un câble de raccordement (L1, L2) posé à l'extérieur du boîtier électronique, lequel dispositif de raccordement comprend un bornier (10) selon l'une des revendications précédentes, ainsi qu'un socle de raccordement (20) pour le bornier, lequel socle est constitué au moins partiellement d'un plastique électriquement isolant.

4. Dispositif de raccordement selon la revendication 3, pour lequel le socle de raccordement (20) comporte
- un corps de base (200) constitué au moins partiellement d'un plastique électriquement isolant ;
- une première électrode de raccordement (P1) disposée sur un premier côté du corps de base formant un premier côté de raccordement du socle de raccordement, laquelle électrode de raccordement (P1) est complémentaire à la première électrode de raccordement (S1) du bornier ; ainsi que
- au moins une deuxième électrode de raccordement (P2) disposée sur le premier côté du corps de base, espacée latéralement de la première électrode de raccordement, laquelle électrode de raccordement (P2) est complémentaire à la deuxième électrode de raccordement (S2) du bornier.

5. Dispositif de raccordement selon la revendication précédente,
- pour lequel le socle de raccordement (20) et le bornier (10) sont reliés entre eux mécaniquement, notamment de manière amovible, en constituant une liaison galvanique, notamment conçue en tant qu'élément de contact mâle, entre la première électrode de raccordement (S1) du bornier (10) et la première électrode de raccordement (P1) du socle de raccordement, ainsi qu'entre la deuxième électrode de raccordement (S2) du bornier (10) et la deuxième électrode de raccordement (P2) du socle de raccordement ; et/ou
- pour lequel chacune des deux électrodes de raccordement (P1, P2) du socle de raccordement (20) est reliée électriquement, notamment par liaison de matière, avec un conducteur d'un circuit électronique (30), lequel conducteur est notamment conçu en tant que piste conductrice sur une carte de circuit imprimé (300).

6. Appareil de terrain, notamment un appareil de mesure et/ou de commutation, comprenant :
- un dispositif de raccordement (10, 20) selon l'une des revendications 3 à 5 ;
- ainsi qu'un circuit électronique (30) relié électriquement avec le même dispositif de raccordement.

7. Appareil de terrain selon la revendication 6, pour lequel le circuit électronique (30) comporte deux électrodes de raccordement (A1, A2), chacune étant au moins conçue partiellement en tant que piste conductrice sur une carte de circuit imprimé (300) et/ou au moins partiellement en tant que fil conducteur, électrodes parmi lesquelles une première électrode de raccordement (A1) est reliée électriquement avec la première électrode de raccordement (P1) du socle de raccordement (20) et une deuxième électrode de raccordement (A2) avec la deuxième électrode de raccordement (P2) du socle de raccordement (20), notamment au moyen d'une connexion soudée.

8. Appareil de terrain selon l'une des revendications 6 à 7, comprenant en outre : un boîtier électronique (H), le dispositif de raccordement (10, 20) et le circuit électronique (30) étant tous deux logés à l'intérieur du boîtier électronique (H).

9. Appareil de terrain selon l'une des revendications 6 à 8, comprenant en outre : un capteur (S) destiné à la génération d'au moins un signal de mesure (sₓ) dépendant d'une grandeur de mesure (x) physique à mesurer.

10. Appareil de terrain selon l'une des revendications 6 à 9, pour lequel le circuit électronique comporte une sortie tout ou rien (30A), notamment constituée d'un transistor et/ou passive, avec une première électrode de sortie (A1) reliée électriquement avec la première électrode de raccordement (P1) du socle de raccordement et avec une deuxième électrode de sortie (A2) reliée électriquement avec la deuxième électrode de raccordement (P2) du socle de raccordement, notamment de telle sorte à constituer, au moyen de la sortie tout ou rien, du socle de raccordement (20) et du bornier (10), une sortie de commutation conforme à la norme européenne EN 60947-5-6:2000.

11. Appareil de terrain selon l'une des revendications 6 à 10, pour lequel le circuit électronique comporte un transistor bipolaire avec une connexion de collecteur formant notamment la première électrode de raccordement (A1) du circuit électronique (30), et avec une connexion d'émetteur formant notamment la deuxième électrode de raccordement (A2) du circuit électronique (30)

12. Appareil de terrain selon la revendication 11, pour lequel, notamment afin de constituer une sortie de commutation conforme à la norme européenne EN 60947-5-6:2000
- la connexion de collecteur du transistor bipolaire est reliée électriquement avec la première électrode de raccordement (P1) du socle de raccordement, et donc via l'élément résistif (R1) avec la première borne de raccordement (K1) du bornier, et
- la connexion d'émetteur du transistor bipolaire est reliée électriquement avec la deuxième électrode de raccordement (P2) du socle de raccordement, et donc avec la deuxième borne de raccordement (K2) du bornier.

13. Appareil de terrain selon l'une des revendications 6 à 11, pour lequel le circuit électronique comporte un transistor à effet de champ avec une connexion de drain formant notamment la première électrode de raccordement du circuit électronique, et avec une connexion de source formant notamment la deuxième électrode de raccordement du circuit électronique.

14. Appareil de terrain selon la revendication 13, pour lequel, notamment afin de constituer une sortie de commutation conforme à la norme européenne EN 60947-5-6:2000,
- la connexion de drain du transistor à effet de champ est reliée électriquement avec la première électrode de raccordement du socle de raccordement, et donc via l'élément résistif avec la deuxième borne de raccordement du bornier, et
- la connexion de source du transistor à effet de champ est reliée électriquement avec la deuxième électrode de raccordement du socle de raccordement, et donc avec la deuxième borne de raccordement du bornier.
